(19) Europäisches Patentamt
European Patent Office
Office européen des brevets

(11) **EP 4 679 105 A1**

(12) **EUROPEAN PATENT APPLICATION**

(43) Date of publication:
**14.01.2026 Bulletin 2026/03**

(21) Application number: **24187784.4**

(22) Date of filing: **10.07.2024**

(51) International Patent Classification (IPC):
**G01R 27/02** (2006.01)   **G01R 27/14** (2006.01)
**G01R 31/28** (2006.01)

(52) Cooperative Patent Classification (CPC):
**G01R 27/14; G01R 27/02;** G01R 31/2851

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Aptiv Technologies AG**
**8200 Schaffhausen (CH)**

(72) Inventor: **PLUTA, Mateusz**
**8200 Schaffhausen (CH)**

(74) Representative: **Lewis Silkin LLP**
**Arbor**
**255 Blackfriars Road**
**London SE1 9AX (GB)**

Remarks:
Amended claims in accordance with Rule 137(2) EPC.

(54) **APPARATUS FOR TESTING ELECTRICAL CHARACTERISTICS OF MULTI-PIN DEVICE**

(57) An apparatus is provided for testing electrical characteristics of a multi-pin device. The apparatus is simultaneously connected to a plurality of pins of the device, and automatically selects measurement settings and calibrations settings. Errors and testing times are reduced significantly in comparison with conventional techniques, such as a per-pin LCR meter.

FIGURE 1

**Description**

<u>Field</u>

The present disclosure relates to an apparatus for testing electrical characteristics of a device, and particularly to testing of electrical characteristics of a multi-pin device. Particularly, but not exclusively, the present disclosure relates to an apparatus for testing electrical characteristics of a multi-pin device before and after an electrostatic discharge (ESD) event is applied to the device, in order to determine with the device has survived the ESD event. The present disclosure concerns a device which can take measurements from the device with automatically configured measurement and calibration settings.

<u>Background</u>

It is common for manufacturers of electrical components to require ESD testing to be performed during, or after, a manufacturing process, in order to test whether an electrical component can survive an everyday ESD event. For example, an ESD event may occur on human contact with metalwork or a pin of an electrical component, with a sudden flow of electricity occurring as a result of the difference in potential between the device and human skin. Even relatively low voltage differences (for example, 10V) may be sufficient to cause ESD which can damage sensitive equipment and cause electrical component failure.

An ESD test is typically performed by applying a high voltage (for example 4kV) electrical spark to a pin of a device using an ESD gun, while the device is switched off. By determining electrical characteristics such as the capacitance and dissipation factors of the device, using a device such as an LCR meter measuring inductance (L), capacitance (C) and resistance (R), it can be determined whether the device has survived the ESD test by comparing electrical characteristics measured before and after the ESD test at each pin.

Many devices to be tested comprise electrical components which have a large number of pins. For example, devices such as automotive controllers, particularly body control modules (BCMs) managing communications between electronic control units, may have hundreds of pins. As such, a single ESD test for the device can very time consuming, given the need to test each pin multiple times before the operation of the device as a whole can be verified. A typical testing time, performed using conventional techniques, can be as long as 16 hours.

Furthermore, due to the number of individual pin tests to be performed, there is significant scope for error. Pins may be tested multiple times by mistake while other pins are accidentally missed altogether. Testing parameters may be inconsistent between different testers, particularly before and after an ESD test, and the need to carefully select signal frequencies, signal amplitudes, and compensations for electrical characteristics of the testing equipment for each test introduces both delay and opportunity for error. Storage of test results and processing of the results to generate a test report for a device is also a complex process for such multi-pin devices.

Embodiments of the present disclosure present an apparatus for testing electrical characteristics of a multi-pin device which aims to address these deficiencies in the testing process.

<u>Summary</u>

According to an aspect of the present invention, there is provided an apparatus for testing electrical characteristics of a multi-pin device, comprising a connector connecting to a plurality of pins of the multi-pin device, a signal generator for generating a test signal, a multiplexer arranged to output a plurality of pin signals by selectively connecting the test signal to each of the plurality of pins through the connector, and a processor for determining electrical characteristics of the multi-pin device from the plurality of pin signals.

By connecting simultaneously to multiple pins of a device under test, and testing each of the pins by automatically multiplexing the pin signals to the apparatus, the number of pins which can be tested per connection is increased, while opportunities for errors are removed. Tests can be performed in a reliable, and repeatable manner.

In embodiments, the electrical characteristics are reactance and equivalent series resistance, ESR. These parameters are affected by damage during an ESD test, and therefore changes in these parameters can be indicative of damage to the device under test. Particularly, ESR increases if the device is damaged, while reactance can be eliminated by as a result of an ESD event.

In embodiments, the test signal is a sinusoidal voltage signal, having an amplitude which is lower that a forward voltage of semiconductor components in the multi-pin device. In this manner, it is ensured that the test signal does not activate any semiconductor components of the device which could power-on the device and affect test results.

In embodiments, the signal generator is a direct digital synthesis, DDS, signal generator, comprising a digital-to-analogue converter arranged to output the sinusoidal voltage signal as an analogue signal determined from a digital control input from the processor, wherein the signal generator further comprises an elliptical filter for filtering noise from the DDS signal generator and a variable gain amplifier for amplifying the filtered signal. In this manner, the test signal is clean and precisely generated, facilitating frequency-domain analysis of test results.

In embodiments, the apparatus comprises a further multiplexer for multiplexing the plurality of pin signals to a measurement signal for input to the processor, wherein the processor comprises a first analogue-to-digital converter arranged to determine the voltage drop of a pin signal from the measurement signal. In this manner it is possible to simplify the connection of multiple signals to the processor, while digitizing the voltage results to facilitate storage.

In embodiments, the apparatus further comprises a measurement module, wherein the measurement module comprises a plurality of shunt resistors arranged between the signal generator and the multiplexer, and an instrumentation amplifier, wherein the measurement module measurement module is configured to derive the current of a pin signal by determining a voltage drop of the pin signal across a selected one of the shunt resistors, using the instrumentation amplifier and outputting a voltage drop signal, wherein the processor is arranged to apply the voltage drop signal to a second analogue-to-digital converter and to determine a voltage drop, and the processor arranged to determine reactance and equivalent series resistance of the multi-pin device from the derived current and the determined voltage drop.

In this manner, current can be determined accurately due to low gain error associated with an instrumentation amplifier, while digitization of the voltage drop facilitates data storage and processing.

In embodiments, each of the plurality of shunt resistors has a different resistance, and the plurality of shunt resistors are configured such that one of the shunt resistors is selected automatically in dependence upon the current of the pin signal. In this manner, it is possible to ensure that a wide range of currents can be derived accurately by the instrumentation amplifier, and that error in calculation of electrical characteristics is reduced. A wide range of devices can therefore be tested.

In embodiments, the apparatus further comprises a first voltage regulation module for outputting a digital voltage supply from a power supply of the apparatus, and a second voltage regulation module for outputting an analogue voltage supply from the power supply of the apparatus, wherein the processor and signal generator are powered by the one or more digital voltage supplies, wherein each of the first and second analogue-to-digital converters is powered by the analogue voltage supply. In this manner, the apparatus has on-board functionality to generate each of the voltage reference signals that it requires, in a stable manner. Furthermore, separate supply voltages reduces errors.

In embodiments, the apparatus further comprises a Fast Fourier Transform, FFT, module, arranged to perform a first FFT on the voltage drop measured by the instrumentation amplifier to obtain a first frequency spectrum for pin signal current, and a second FFT on the voltage of the pin signal to obtain a second frequency spectrum for pin signal voltage, wherein the FFT module is arranged to obtain real and imaginary components of the peaks of each of the first and second frequency spectra having highest energy, wherein the processor is arranged to determine reactance and equivalent series resistance from the obtained real and imaginary components of the first and second frequency spectra.

In this way, parameters of the pin signals can be determined accurately using a relatively small number of samples.

In embodiments, the processor is arranged to set a frequency of the test signal in dependence upon a sampling rate of the FFT module, in which the sampling rate of the FFT module is a $2^n$ multiple of the frequency of the test signal, for integer n. In this way, distortion in the FFT process is reduced, as spectral leakage between successive sample windows is removed.

In embodiments, the apparatus comprises a calibration module for obtaining reactance and equivalent series resistance of the selected shunt resistor, wherein the processor is arranged to compensate for the reactance and equivalent series resistance of the selected shunt resistor when determining the reactance and equivalent series resistance of the multi-pin device.

In this way, an automatic process is performed in order to determine the effect of the apparatus on the measured characteristics, in a way which preserves accuracy of results without the need for an operator to manually compensate for the apparatus for each pin measurement.

In embodiments, the processor is arranged to determine capacitance and a dissipation factor for the multi-pin device from the determined reactance and equivalent series resistance.

In embodiments, the signal generator is arranged to output a first test signal, and the processor is arranged to determine a first set of electrical characteristics from a first set of pin signals, wherein the signal generator is further arranged to output a second test signal, and the processor is arranged to determine a second set of electrical characteristics from a second set of pin signals, wherein the processor is arranged to compare the first set of measurement signals with the second set of measurement signals. In this way it is possible to both observe changes occurring over a period of time, such as parametric drift, and to average to compensate for any measurement errors which do arise on an individual measurement, for example, caused by processing error or noise on the connection between the apparatus and the device under test.

In embodiments, the apparatus is arranged to output an instruction to the multi-pin device to discharge one or more capacitors of the multi-pin device after an electrostatic discharge, ESD, test, wherein the signal generator is arranged to output the first test signal before the ESD test is performed, and to output the second test signal after the ESD is performed, wherein the processor is arranged to determine the effect of the ESD test on the multi-pin device, by comparing the first set of electrical characteristics and the second set of electrical characteristics.

In this way, it is not necessary for a user to perform this process manually, which can otherwise be very time consuming.

**Brief Description of Drawings**

Illustrative embodiments will now be described with reference to the drawings in which:

Figure 1 shows an apparatus for testing electrical characteristics of a multi-pin device, according to a first embodiment;
Figure 2 shows the construction of the signal generator of the testing apparatus of Figure 1, according to the first embodiment; and
Figure 3 shows a measurement module used in a testing apparatus according to a second embodiment.

**Detailed Description**

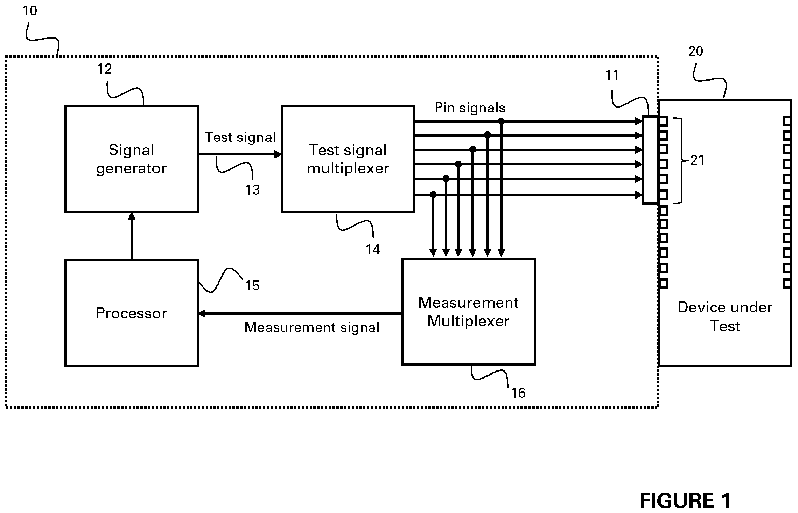

Figure 1 shows an apparatus 10 for testing electrical characteristics of a multi-pin device 20, according to a first embodiment. The apparatus 10 comprises a connector 11 for connecting to a plurality of pins of the device under test (DUT) 20. In the illustrated embodiment, the connector 11 connects to six pins 21, but this is simply by way of example, and a reduced total set of pins for the DUT 20 is illustrated in Figure 1 for simplicity.

The apparatus comprises a signal generator 12 for generating a test signal 13. The test signal 13 is to be applied to the DUT 20, and the state of the DUT 20 influences how the test signal 13 is affected and measured by the testing apparatus 10 as a test result. For example, if the DUT 20 is damaged, it may have very low equivalent series resistance, due to destruction of capacitors by a short circuit, such that the current of the test signal 13 is increased substantially from what would otherwise be expected.

The output of the signal generator 12 is provided to a test signal multiplexer 14, which selectively connects the signal generator 12 to one of the plurality of pins 21 to which the testing apparatus 10 is connected. In this way, the testing apparatus 10 is able to output any of a plurality of signals based on a single physical connection to the DUT 20, by the operation of the multiplexer 14. Ideally, the multiplexer 14 has a low drain-source on-resistance (Rds_on) and low capacitance.

The testing apparatus 10 further comprises a processor 15 for determining electrical characteristics of the DUT 20. The testing apparatus 10 comprises a measurement multiplexer 16 comprising a plurality of inputs, each of which is connectable to the pins 21 of the DUT, so that a measurement signal can be selectively connected to the processor 15 from each pin, in the manner described below. In doing so, the paths between the signal generator 12 and the DUT pins 21 are separate from the paths between the processor 15 and the DUT pins 21. An ADC may be present between the voltage drop multiplexer 16 and the processor 15 in order to digitize parameters of the pin signals. As will be described in detail below, the measurement signal may correspond to a voltage difference between

The processor 15 executes one or more sets of computer-readable instructions which define algorithms for processing information which is derived from the test signals, in order to enable test data for the DUT 20 to be generated. The processor 15 can compile multiple sets of test data for the DUT 20 to enable a test report to be generated for a particular period of time, to enable particular diagnostic information, such as specific ESD failure modes, to be identified.

The operation of the multiplexer 14 ensures that all pins of a DUT 20 can be tested with a significantly reduced number of physical connection events in comparison to those required in a conventional pin-by-pin testing environment.

The physical connector 11 takes the form of a body comprising a plurality of pin connections. The connections may take any appropriate form for connecting to the DUT 20. In embodiments, a test environment is configured for the DUT 20 comprising a chip socket to accommodate the DUT 20, and a plurality of lead-out out connections from each pin of the socket to a physical connector suitable for interfacing with the connector 11 of the first embodiment, whether as a male or female connector. The body may comprise one or more screws on an outer flange surrounding the body of connections, which is affixed to a corresponding receiver for the screws on the DUT 20 or the socket lead-out interface. This ensures a tight, stable connection which remains consistent for the duration of each of the pin signal tests.

In operation, the signal generator 12 applies the same test signal 13, in sequence, to each of the pins of the DUT 20, by switching the multiplexer 14 through the sequence of connections. In embodiments, the test signal 13 is a sinusoidal signal having an amplitude corresponding to a voltage which is lower than the minimum forward voltage of semiconductors of the DUT 20.

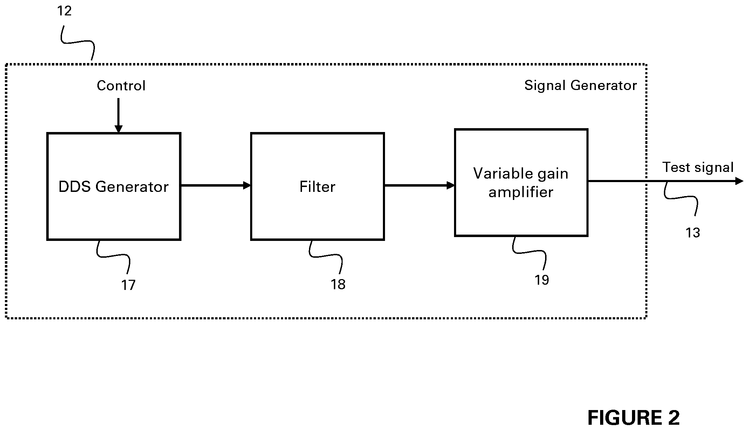

Figure 2 shows the construction of the signal generator 12 of the testing apparatus 10 of Figure 1, according to the first embodiment. The signal generator 12 comprises a direct digital synthesis (DDS) generator 17, which outputs a sinusoidal signal having a digitally-defined frequency, based on a control signal. In embodiments, the control signal is provided by the processor 15, and the DDS generator receives a reference supply voltage, such as a digital 3.3V reference.

A signal sinusoidal generated by the DDS generator 17 is input to a filter 18 such as an elliptical filter which attenuates high-frequency noise from the signal. An elliptical filter has a sharp cut-off between the passband and the stopband. The elliptical filter may be designed by an analogue circuit simulation tool such as LTSpice, based on a desired cut-off frequency and filter order. An illustrative cut-off frequency is of the order of 10-20 MHz.

The filtered signal is passed through a variable gain amplifier (VGA) 19 in order generate the desired amplitude of the test signal 13 for a particular DUT 20. Ideally, the VGA 19 is selected such that it has low input offset voltage, low common mode rejection ratio (CMRR), low power supply rejection ratio (PSRR), high frequency bandwidth, dual supply, low bias current and low offset current.

An illustrative amplitude, used in embodiments of the disclosure, is 0.4V, which is below a common forward voltage of semiconductor components of a DUT of 0.7V. An illustrative frequency is 5-10 kHz.

Use of a sinusoidal signal enables reactance to be measured at the DUT 20, based on the resistance to alternating current. The reactance has capacitive and inductive components, each of which is frequency-dependent. Both reactive and resistive parameters at the DUT 20 will affect the current of the test signal 13 as it is applied to a particular pin, for a given voltage of test signal 13. As such, by measuring the current and voltage of the pin signal, it is possible to determine electrical characteristics of the DUT 20, particularly its equivalent series resistance, and its reactance. From such figures, and based on the frequency of the test signal 13, it is possible to measure the capacitance and dissipation factor of the DUT 20.

In some embodiments, the configuration of the signal generator is selected automatically by the processor 15 using test parameters pre-stored in a memory. In this manner, the testing apparatus 10 is ready to test as soon as it is switched on, without requiring manual calibration. Further, the same configuration can be applied for testing each pin signal, significantly reducing measurement errors.

The testing apparatus 10 of the first embodiment may be used to determine electrical characteristics of the DUT 20 before and after an ESD test is applied to the DUT 20. The purpose of this to determine whether the device has survived the application of a high voltage ESD event, so that it can be inferred whether the device 20 has sufficient robustness to pass a manufacturer's requirements. If the DUT 20 has failed to survive an ESD, it will have a low dissipation factor, and low equivalent series resistance, due to, for example, destruction of capacitors by a short circuit caused by the ESD test. Consequently, the effect of an ESD event can be determined quickly and reliably by connecting the connector to successive groups of pins of the device, rather than having to perform connections on a per-pin basis. Consequently, the likelihood of an individual pin being accidentally measured multiple times, or not at all, is removed, while it can be ensured that the same parameters of the signal generator 12 are used for each pin signal of the test.

In embodiments, the processor 15 is configured to output an instruction to discharge the capacitors of the DUT 20 after an ESD test is performed, so that the DUT 20 is ready to be tested again.

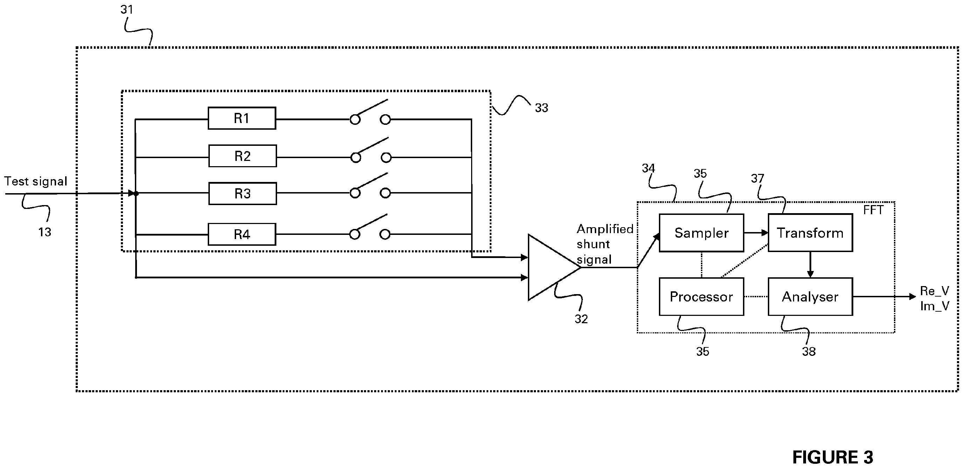

The apparatus 10 of the first embodiment of Figure 1 uses the processor 15 to determine electrical characteristics of the pin signals using on-board circuitry to measure parameters such as voltage and current. The processor 15 may comprise one or more analogue-to-digital converters (ADC's) for digitizing the analogue pin signals, and sampling them in order to derive particular parameters such as voltage and current. The apparatus of a second embodiment, described with reference to Figure 3, comprises a dedicated measurement module 31 for measuring such parameters, as described below. The measurement module 31 is positioned between the signal generator 12 and the test multiplexer 14, but otherwise the testing apparatus of the second embodiment is as shown in Figure 1.

In order to measure the current of the test signal 13, the voltage drop when the test signal 13 current flows through a test resistor, referred to herein as a shunt resistor, is measured, such that current flow can be calculated based on Ohm's Law. The shunt resistor is contained within the measurement unit 31, and the voltage across the shunt resistor is measured using an amplifier 32. An instrumentation amplifier is used as a result of its low gain error, low input offset voltage, low output offset voltage, low CMRR, low PSRR, low offset current, low bias current, dual supply, high frequency bandwidth and variable gain.

In embodiments, the shunt resistor is part of a network 33 of shunt resistors. The network 33 of shunt resistors comprises a plurality of resistors in parallel (four shunt resistors, R1-4, are illustrated by way of example), and the instrumentation amplifier 32 is arranged to measure a voltage drop across a selected one of the shunt resistors. The selection is performed via activation of a switch or relay.

Each shunt resistor has a different resistance R1, R2, R3, R4. The shunt resistor to be used for voltage measurement is selected in dependence on the current of the test signal 13. Particularly, a test signal 13 having a current which is within a particular range, is such that a particular switch or relay is activated to enable an accurate measurement of the current to be performed.

If the current is low, it is desirable for a high resistance shunt to be selected, so that the voltage drop across the shunt is higher for a given current. Conversely, if the current is high, it is desirable for a low resistance shunt to be selected, so that the voltage drop across the shunt is lower for a given current. With this approach, it can be ensured that the voltage drops sensed by the instrumentation amplifier 32 are always within a particular operating range. In contrast, if a single shunt resistance were to be used, the voltage sensed by the instrumentation amplifier 32 would vary in proportion to the current, and could reach operational limits of the amplifier. Consequently, a wide range of devices can be tested, and a wide range of currents can be measured using the configuration of Figure 3.

Since the test signal 13 contains alternating current as a result of the sinusoidal signal which is generated, the voltage signal which is output by the instrumentation amplifier 32 is an alternating signal. The frequency of the instrumentation amplifier output is that of the test signal 13. A Fast Fourier Transform (FFT) 34 is employed, in embodiments of the present disclosure, in order to determine the amplitude of the alternating shunt signal at a given frequency. In the ideal case, the frequency spectrum of the signal output by the instrumentation amplifier 32 is a single peak at the frequency of the test signal, although additional noise sources may introduce other minor peaks in the spectrum. The magnitude of the largest energy peak in the frequency spectrum provides a measure of the peak shunt voltage at the test frequency, from which the current through the corresponding shunt resistor is determined.

The use of an FFT algorithm is advantageous, as it enables elimination of signal variations which are not at the frequency of the test signal 13, while a relative slow sampling speed, in comparison to the measured signal frequency, can be used. In embodiments of the present disclosure, a $2^n$ multiplier, for integer n, is applied to the signal frequency in order to set the sampling rate. In one embodiment, n = 5, such that only 32 signal samples per sampling frame are required, but larger values of n may be used in other embodiments. The multiplier of $2^n$ ensures that each sampling window contains complete phase loops of the sampled signal, and the choice of n determines the resolution of the FFT in terms of the size of the frequency bins which are derived.

The spectral analysis of the FFT leads to the peak voltage of the shunt signal, from which a peak current of the pin signal is derived using Ohm's Law. The peak current is digitized using an ADC (not shown), and is output to the processor 15 for further calculations to be performed.

The FFT is performed using an FFT module 34 which comprises a processor 35 which executes an algorithm for performing a Fast Fourier transform, and controls other modules within the FFT module 34. The FFT module 34 comprises a sampler 36, for sampling an input signal, and a transform module 37 for transforming a time-series of sampled signals into the frequency domain, in a manner which will be well understood in the art. The output of the transform module 37 is a frequency spectrum of the signal received by the sampler 35, and a spectrum analyser 38 analyses the spectrum in order to identify the size of the energy peak at the frequency of the test signal. The energy peak is proportional to the square of the peak shunt voltage, from which the pin signal current is derived. The energy peak is digitized using an analogue-do-digital converter to facilitate further storage and processing by processor 15.

In order to determine the equivalent series resistance and reactance of the DUT 20, it is necessary to determine the voltage of the pin signal as well as the current. The voltage of the pin signal at the DUT 20, is measured by the processor 15 based on the signal from the DUT 20 which is provided via the measurement multiplexer 16. This voltage enables calculation of the 'full' voltage drop between the testing apparatus 10 and the DUT 20. The voltage drop provides information as to the proportion of the voltage of the test signal 13 which drops in the DUT 20 itself. For example, if the full voltage drop corresponds to the peak voltage of the test signal 13, then it can be inferred that there is no voltage drop in the DUT 20 itself, and all of the voltage of the test signal 13 drops across the shunt resistor. If the full drop corresponds to a fraction of the peak voltage of the test signal 13, then it can be inferred that there is an additional fraction of the voltage of the test signal 13 which drops within the DUT 20 itself. For example, if the DUT 20 has been damaged by an ESD test, it may have low resistance, such that little voltage of the test signal 13 drops between the testing apparatus 10 and the DUT 20.

The full voltage drop is analysed by performing an FFT on the pin signal. The operation is performed in a similar manner as that described above. As such, there are two FFT operations which are performed - one on the shunt signal, and one on the full voltage drop between the testing apparatus 10 and the DUT 20. The FFT operations can be performed by switching the sampled input to the transform module 37 of the FFT module 34, so as to perform the FFTs in series, or a second instance of the FFT module 34 can be used to enable performance of two FFTs in parallel.

In embodiments, the FFT module 34 is implemented within the processor 15, rather than within measurement module 31, so that the processor 15 performs an FFT of the current signal determined from the shunt network 33 between the signal generator 12 and the test signal multiplexer 14, and the voltage signal provided via measurement multiplexer 16. In embodiments, an amplifier is arranged between multiplexer 16 and processor 15. An amplifier with high input impedance will draw only a small current which leads to accurate voltage measurement.

The references above to the voltages associated with the energy peaks of the frequency spectra are references to a combination of the real and imaginary parts of the voltage signals, which the FFT is able to resolve. The real and imaginary voltages and currents are combined using expressions (1) and (2) in order to determine the ESR, and reactance, X, of the DUT. In expressions (1) and (2), Max_real_V and Max_imag_V are the maximum real and imaginary parts of the full DUT voltage drop respectively, while Max_real_I and Max_imag_I are the maximum real and imaginary parts of the current accordingly, derived from the real and imaginary maxima of the shunt voltage.

$$ESR = \frac{Max\_real\_V \cdot Max\_real\_I + Max\_imag\_V \cdot Max\_imag\_I}{Max\_real\_I \cdot Max\_real\_I + Max\_imag\_I \cdot Max\_imag\_I} \qquad (1)$$

$$X = \frac{Max\_imag\_V \cdot Max\_real\_I - Max\_real\_V \cdot Max\_imag\_I}{Max\_real\_I \cdot Max\_real\_I + Max\_imag\_I \cdot Max\_imag\_I} \qquad (2)$$

Using these parameters, the dissipation factor, DF, of the DUT can be calculated using the ratio DFR = ESR / X.

Device capacitance is calculated using C = 1/(2•π•f•X), for frequency f.

Equivalent series resistance, reactance, dissipation factor, and capacitance values are determined. In some embodiments, such values are incorporated into a report, or for further analysis. The report may be generated using on-board processing at the testing apparatus 10, but in embodiments, the testing apparatus 10 outputs parameter values over an interface such as an RS-232 connection to an external processing device or computer. An advantage of the embodiments is that the data can be transmitted quickly on a per-pin basis.

The use of shunt resistors, particularly those of high resistance, can introduce phase shifts into the pin signal, and such phase shifts can cause errors in the ESR, due to the effect of the phase shift on the relationship between the real and imaginary parts of the voltage and current determined from the respective FFTs. In embodiments of the present disclosure, it is possible to compensate for such errors based on a combination of open/short/load compensation techniques to determine residual impedances, particularly reactance and ESR, associated with the connection between the shunt resistor and the DUT.

Open compensation involves measuring and compensating for open circuit residual impedance in parallel with the shunt resistor, which is mainly associated with capacitance in the connections. Short-circuit compensation involves measuring and compensating for residual impedance in series with the shunt resistor, which is mainly associated with resistance and inductance in the connections. Load compensation involves using a nominal load, in place of the DUT, in which the nominal load has an impedance which is in the centre of the measurement range for each shunt path order to determine the deviation from the nominal load by the residual impedance of the shunt. In embodiments of the present disclosure, using a capacitor as a nominal load, having capacitance at the centre of the measurement range for each shunt (taking into account the range of current measurement of the shunt, and thus the shunt resistance itself) enables compensation for capacitance, while using an inductor as a nominal load similarly enables compensation for inductance.

Full details of the implementation of open/short/load compensation will be apparent to those skilled in the art, and are not reproduced here in the interests of conciseness. The output of the compensation is a calibration parameter or offset to be applied to measured results in order to determine a true characteristic of the device. Advantages of the present embodiments are that such calibration can be determined automatically by the testing apparatus 10 and calibration parameters are stored in a memory for reuse. It is not necessary for a user to make manual changes each time a new pin signal is tested, although automatic calibration and compensation is performed before each power-up of the testing apparatus 10 for a testing operation. This significantly speeds up the testing process so that in addition to a time-saving associated by measuring multiple pin signals using only a single physical connection 11, the need for manual adjustment of calibration parameters for each signal can be avoided, which makes the saving in processing time yet greater.

Compensation is performed, in embodiments, by the processor 15, but in other embodiments, a standalone compensation module, operating under the control of processor 15, executes the calibration routine instead.

Load compensation is needed during usage of the testing apparatus 10, but is not essential to perform open and short compensation in addition.

The testing apparatus 10 of embodiments of the present disclosure comprises an on-board voltage reference in order to generate each of the voltage supplies that it requires, in a stable manner. Furthermore, separate supply voltages reduce errors.

In particular, the testing apparatus 10 comprises an analogue voltage reference, and one or more digital voltage references. Each voltage reference is output by a respective voltage regulator, such as a high-precision low-dropout regulator, coupled to the main power supply of the testing apparatus. The analogue voltage reference powers each of the ADCs, while the digital reference voltages power the signal generator 12 and the processor 45.

It will be appreciated that a number of modifications to the described embodiments can be made within the scope of the attached claims, dependent on the number of nature of the tests to be performed. For example, the number of pin connections, the number of repeat tests, and the nature of the processing of the rest results can be adjusted in dependence on the specific testing process.

**Claims**

1. An apparatus for testing electrical characteristics of a multi-pin device, comprising:

   a connector connecting to a plurality of pins of the multi-pin device;
   a signal generator for generating a test signal;
   a multiplexer arranged to output a plurality of pin signals by selectively connecting the test signal to each of the plurality of pins through the connector; and
   a processor for determining electrical characteristics of the multi-pin device from the plurality of pin signals.

2. An apparatus according to claim 1, wherein the electrical characteristics are reactance and equivalent series resistance.

3. An apparatus according to claim 2, wherein the test signal is a sinusoidal voltage signal, having an amplitude which is lower that a forward voltage of one or more semiconductor components in the multi-pin device.

4. An apparatus according to claim 3, wherein the signal generator is a direct digital synthesis, DDS, signal generator, comprising a digital-to-analogue converter arranged to output the sinusoidal voltage signal as an analogue signal determined from a digital control input from the processor,
   wherein the signal generator further comprises an elliptical filter for filtering noise from the DDS signal generator and a variable gain amplifier for amplifying the filtered signal.

5. An apparatus according to claim 3 or claim 4, comprising a further multiplexer for multiplexing the plurality of pin signals to a measurement signal for input to the processor, wherein the processor comprises a first analogue-to-digital converter arranged to determine the voltage drop of a pin signal from the measurement signal.

6. An apparatus according to claim 5, comprising a measurement module, wherein the measurement module comprises:

   a plurality of shunt resistors arranged between the signal generator and the multiplexer; and
   an instrumentation amplifier;
   wherein the measurement module is configured to derive the current of a pin signal by determining a voltage drop of the pin signal across a selected one of the shunt resistors, using the instrumentation amplifier and outputting a voltage drop signal,
   wherein the processor is arranged to apply the voltage drop signal to a second analogue-to-digital converter and to determine a voltage drop, and
   the processor arranged to determine reactance and equivalent series resistance of the multi-pin device from the derived current and the determined voltage drop.

7. An apparatus according to claim 6, wherein each of the plurality of shunt resistors has a different resistance, and the plurality of shunt resistors are configured such that one of the shunt resistors is selected automatically in dependence upon the current of the pin signal.

8. An apparatus according to any one of claims 5 to 7, comprising:

   a first voltage regulation module for outputting one or more digital voltage supply from a power supply of the apparatus;
   a second voltage regulation module for outputting an analogue voltage supply from the power supply of the apparatus;
   wherein the processor and signal generator are powered by the one or more digital voltage supplies,
   wherein each of the first and second analogue-to-digital converters is powered by the analogue voltage supply.

9. An apparatus according to any one of claims 6 to 8, further comprising a Fast Fourier Transform, FFT, module, arranged to perform a first FFT on the voltage drop measured by the instrumentation amplifier to obtain a first frequency spectrum for pin signal current, and a second FFT on the voltage of the pin signal to obtain a second frequency spectrum for pin signal voltage;

   wherein the FFT module is arranged to obtain real and imaginary components of the peaks of each of the first and second frequency spectra having highest energy;

wherein the processor is arranged to determine reactance and equivalent series resistance from the obtained real and imaginary components of the first and second frequency spectra.

10. An apparatus according to claim 9, wherein the processor is arranged to set a frequency of the test signal in dependence upon a sampling rate of the FFT module, in which the sampling rate of the FFT module is a $2^n$ multiple of the frequency of the test signal, for integer n.

11. An apparatus according to claim 10, comprising a calibration module for obtaining reactance and equivalent series resistance of the selected shunt resistor,

wherein the processor is arranged to compensate for the reactance and equivalent series resistance of the selected shunt resistor when determining the reactance and equivalent series resistance of the multi-pin device.

12. An apparatus according to any one of claims 2 to 11, wherein the processor is arranged to determine capacitance and a dissipation factor for the multi-pin device from the determined reactance and equivalent series resistance.

13. An apparatus according to any one of the preceding claims, wherein the signal generator is arranged to output a first test signal, and the processor is arranged to determine a first set of electrical characteristics from a first set of pin signals,

wherein the signal generator is further arranged to output a second test signal, and the processor is arranged to determine a second set of electrical characteristics from a second set of pin signals;

wherein the processor is arranged to compare the first set of measurement signals with the second set of measurement signals.

14. An apparatus according to claim 12, wherein the apparatus is arranged to output an instruction to the multi-pin device to discharge one or more capacitors of the multi-pin device after an electrostatic discharge, ESD, test,

wherein the signal generator is arranged to output the first test signal before the ESD test is performed, and to output the second test signal after the ESD is performed,

wherein the processor is arranged to determine the effect of the ESD test on the multi-pin device, by comparing the first set of electrical characteristics and the second set of electrical characteristics.

**Amended claims in accordance with Rule 137(2) EPC.**

1. An apparatus (10) for testing electrical characteristics of a multi-pin device (20), comprising:

a connector (11) connecting to a plurality of pins (21) of the multi-pin device (20);

a signal generator (12) for generating a test signal (13);

a multiplexer (14) arranged to output a plurality of pin signals by selectively connecting the test signal to each of the plurality of pins through the connector; and

a processor (15) for determining electrical characteristics of the multi-pin device from the plurality of pin signals, wherein the electrical characteristics are reactance and equivalent series resistance and wherein the processor is arranged to determine capacitance and a dissipation factor for the multi-pin device from the determined reactance and equivalent series resistance.

2. An apparatus according to claim 1, wherein the test signal (13) is a sinusoidal voltage signal, having an amplitude which is lower that a forward voltage of one or more semiconductor components in the multi-pin device (20).

3. An apparatus according to claim 2, wherein the signal generator (12) is a direct digital synthesis, DDS, signal generator (17), comprising a digital-to-analogue converter arranged to output the sinusoidal voltage signal as an analogue signal determined from a digital control input from the processor (15),

wherein the signal generator further comprises an elliptical filter (18) for filtering noise from the DDS signal generator and a variable gain amplifier (19) for amplifying the filtered signal.

4. An apparatus according to claim 2 or claim 3, comprising a further multiplexer (16) for multiplexing the plurality of pin signals to a measurement signal for input to the processor (15), wherein the processor comprises a first analogue-to-digital converter arranged to determine the voltage drop of a pin signal from the measurement signal.

5. An apparatus according to claim 4, comprising a measurement module (31), wherein the measurement module comprises:

a plurality of shunt resistors (33) arranged between the signal generator (12) and the multiplexer (14); and
an instrumentation amplifier (32);
wherein the measurement module is configured to derive the current of a pin signal by determining a voltage drop of the pin signal across a selected one of the shunt resistors, using the instrumentation amplifier and outputting a voltage drop signal,
wherein the processor (15) is arranged to apply the voltage drop signal to a second analogue-to-digital converter and to determine a voltage drop, and
the processor arranged to determine reactance and equivalent series resistance of the multi-pin device (20) from the derived current and the determined voltage drop.

6. An apparatus according to claim 5, wherein each of the plurality of shunt resistors (33) has a different resistance, and the plurality of shunt resistors are configured such that one of the shunt resistors is selected automatically in dependence upon the current of the pin signal.

7. An apparatus according to any one of claims 4 to 6, comprising:

a first voltage regulation module for outputting one or more digital voltage supply from a power supply of the apparatus (10);
a second voltage regulation module for outputting an analogue voltage supply from the power supply of the apparatus;
wherein the processor (15) and signal generator (12) are powered by the one or more digital voltage supplies,
wherein each of the first and second analogue-to-digital converters is powered by the analogue voltage supply.

8. An apparatus according to any one of claims 5 to 7, further comprising a Fast Fourier Transform, FFT, module (34), arranged to perform a first FFT on the voltage drop measured by the instrumentation amplifier (32) to obtain a first frequency spectrum for pin signal current, and a second FFT on the voltage of the pin signal to obtain a second frequency spectrum for pin signal voltage;

wherein the FFT module is arranged to obtain real and imaginary components of the peaks of each of the first and second frequency spectra having highest energy;
wherein the processor (15) is arranged to determine reactance and equivalent series resistance from the obtained real and imaginary components of the first and second frequency spectra.

9. An apparatus according to claim 8, wherein the processor is arranged to set a frequency of the test signal (13) in dependence upon a sampling rate of the FFT module (34), in which the sampling rate of the FFT module is a $2^n$ multiple of the frequency of the test signal, for integer n.

10. An apparatus according to claim 9, comprising a calibration module for obtaining reactance and equivalent series resistance of the selected shunt resistor,
wherein the processor (15) is arranged to compensate for the reactance and equivalent series resistance of the selected shunt resistor when determining the reactance and equivalent series resistance of the multi-pin device (20).

11. An apparatus according to any one of the preceding claims, wherein the signal generator (12) is arranged to output a first test signal, and the processor (15) is arranged to determine a first set of electrical characteristics from a first set of pin signals,

wherein the signal generator is further arranged to output a second test signal, and the processor is arranged to determine a second set of electrical characteristics from a second set of pin signals;
wherein the processor is arranged to compare the first set of measurement signals with the second set of measurement signals.

12. An apparatus according to claim 11, wherein the apparatus is arranged to output an instruction to the multi-pin device (20) to discharge one or more capacitors of the multi-pin device after an electrostatic discharge, ESD, test,

wherein the signal generator (12) is arranged to output the first test signal before the ESD test is performed, and to output the second test signal after the ESD is performed,

wherein the processor (15) is arranged to determine the effect of the ESD test on the multi-pin device, by comparing the first set of electrical characteristics and the second set of electrical characteristics.

FIGURE 1

Signal Generator

Control

DDS Generator

17

Filter

18

Variable gain amplifier

19

Test signal

13

12

**FIGURE 2**

**FIGURE 3**

Europäisches
Patentamt

European
Patent Office

Office européen
des brevets

# EUROPEAN SEARCH REPORT

**Application Number**

EP 24 18 7784

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/289636 A1 (HERNANDEZ MARCOS [US]) 26 November 2009 (2009-11-26) | 1,2,5,8, 13 | INV. G01R27/02 |
| A | * paragraphs [0001], [0006] - [0012], [0021] - [0034], [0042] - [0044]; figures 1, 2, 5 * | 3,4,6,7, 9-12,14 | G01R27/14 G01R31/28 |
| X | US 2008/243740 A1 (HAUPTMAN STEVEN L [US]) 2 October 2008 (2008-10-02) | 1,2,5,8, 13 | |
| A | * paragraphs [0023] - [0031]; figures 1-2 * | 3,4,6,7, 9-12,14 | |
| X | US 2018/180652 A1 (SESTOK IV CHARLES KASIMER [US] ET AL) 28 June 2018 (2018-06-28) | 1,2,5,8, 13 | |
| A | * paragraphs [0005] - [0007], [0017] - [0040]; figures 1-3 * | 3,4,6,7, 9-12,14 | |

**TECHNICAL FIELDS SEARCHED (IPC)**

G01R

The present search report has been drawn up for all claims

| Place of search | Date of completion of the search | Examiner |
|---|---|---|
| Munich | 19 December 2024 | Maric, Viktor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 7784

This annex lists the patent family members relating to the patent documents cited in  the above-mentioned European search report.
The members are as contained in the European Patent Office EDP file on
The European Patent Office is in no way liable for these particulars which are merely given for the purpose of information.

19-12-2024

| Patent document cited in search report | Publication date | Patent family member(s) | Publication date |
|---|---|---|---|
| US 2009289636 A1 | 26-11-2009 | NONE | |
| US 2008243740 A1 | 02-10-2008 | DE 112008000865 T5 | 11-02-2010 |
| | | JP 5460574 B2 | 02-04-2014 |
| | | JP 2010523981 A | 15-07-2010 |
| | | TW 200842384 A | 01-11-2008 |
| | | US 2008243740 A1 | 02-10-2008 |
| | | WO 2008124338 A2 | 16-10-2008 |
| US 2018180652 A1 | 28-06-2018 | NONE | |

EPO FORM P0459

For more details about this annex : see Official Journal of the European Patent Office, No. 12/82